## Europäisches Patentamt
## European Patent Office
## Office européen des brevets

(11) Numéro de publication: **0 030 170**
**B1**

(12) **FASCICULE DE BREVET EUROPEEN**

(45) Date de publication du fascicule du brevet:
25.05.83

(21) Numéro de dépôt: **80401531.1**

(22) Date de dépôt: **29.10.80**

(51) Int. Cl.³: **C 01 B 13/36,** C 30 B 29/28,
C 01 F 17/00, C 01 G 15/00

(54) **Procédé de fabrication de grenat polycristallin.**

(30) Priorité: **09.11.79 FR 7927657**

(43) Date de publication de la demande:
**10.06.81 Bulletin 81/23**

(45) Mention de la délivrance du brevet:
**25.05.83 Bulletin 83/21**

(84) Etats contractants désignés:
**AT BE CH DE FR GB IT LI NL SE**

(56) Documents cités:
**US-A-3 395 919**
**US-A-3 681 011**
**CHEMICAL ABSTRACTS, vol. 83, no. 10, 8**
**septembre 1975, ref. 82187s, page 192 Columbus,**
**Ohio, US**
**CHEMICAL ABSTRACTS, vol. 70, 1969, no. 20, ref.**
**92802j, page 414, Columbus, Ohio, US V. I.**
**PLOTNIKOV et al.: »Coprecipitation of indium**
**with rare earth hydroxides from alkali solutions«**

(73) Titulaire: **RHONE-POULENC SPECIALITES CHIMIQUES,**
**"Les Miroirs" 18, Avenue d'Alsace, F-92400 Courbevoie**
**(FR)**

(72) Inventeur: **Boudot, Bernard, 146, Boulevard Diderot,**
**F-75012 Paris (FR)**
Inventeur: **Nury, Georges, 28, Rue Marcel Adam,**
**F-95740 Frepillon (FR)**

(74) Mandataire: **Savina, Jacques et al, RHONE-POULENC**
**RECHERCHES Service Brevets Chimie et**
**Polymères 25, Quai Paul Doumer, F-92408 Courbevoie**
**Cedex (FR)**

Procédé de fabrication de grenat polycristallin

La présente invention concerne un procédé de fabrication d'un oxyde mixte polycristallin présentant la structure grenat, le grenat polycristallin obtenu et le monocristal correspondant.

L'emploi de monocristaux à structure grenat, notamment comme substrats pour la fabrication des dispositifs de mémoires à bulles magnétiques, est notoirement connu.

Pour cette utilisation, les monocristaux de grenat sont essentiellement fabriqués par tirage Czochralski des oxydes mixtes polycristallins présentant la structure grenat, et ci-après dénommés grenats polycristallins.

Actuellement, les grenats polycristallins sont préparés selon trois procédés.

Le premier de ces procédés (décrit par exemple dans »Journal of Crystal Growth« 12 (1972) 3—8) consiste à opérer par mélange des différents oxydes entrant dans la composition du grenat selon les étapes suivantes:

— on calcine séparément les différents oxydes entrant dans la composition du grenat;
— on pèse les quantités fixées par la formule du grenat pour les différents oxydes;
— on mélange mécaniquement les oxydes et on densifie le mélange obtenu par pressage;
— on introduit le mélange densifié dans le creuset de tirage;
— on opère la fusion du mélange.

Ce procédé présente essentiellement deux inconvénients. D'une part, lors du chauffage du mélange, il est impossible de caractériser la structure grenat du mélange polycristallin dont l'apparition dépend du programme de montée en température mis en œuvre; d'autre part, du fait de l'évaporation de certaines sous-espèces, seules des relations empiriques permettent de connaître la composition du bain au moment du tirage en fonction de sa composition à température ambiante.

Le second de ces procédés (décrit par exemple dans le brevet allemand DE 2 615 554) consiste à opérer par mélange puis calcination des différents oxydes entrant dans la composition du grenat de façon à obtenir la structure grenat préalablement à l'opération de fusion. Les conditions de calcination (température et durée) sont déterminées en fonction des cinétiques de réactions solide-solide qui dépendent elles-mêmes essentiellement des propriétés physiques des oxydes mis en œuvre et de leurs teneurs en impuretés.

Ce procédé est le plus couramment utilisé pour la préparation des grenats polycristallins; il permet, par rapport au premier procédé, une meilleure connaissance de la composition du bain au moment du tirage du fait de la possibilité de caractérisation de la structure grenat. Toutefois, ce procédé présente l'inconvénient de nécessiter généralement des calcinations de longue durée qui s'avèrent ne pas toujours conduire à des réactions complètes entre les oxydes. Par exemple, dans le cas d'un grenat de $GD_3Ga_5O_{12}$ une calcination de 100 heures à 1350°C du mélange de 3 moles de $Gd_2O_3$ pour 5 moles de $Ga_2O_3$ conduit à un mélange dans lequel 10% en poids du $Ga_2O_3$ n'a pas réagi.

Le troisième de ces procédés, décrit par exemple dans »Journal of Crystal Growth 19 (1979) 204—208, consiste à décomposer thermiquement le mélange en solution des sels (carbonates, nitrates, chlorures, ammonium, sulfates, ...) des différents éléments constituant le grenat puis à traiter thermiquement le mélange jusqu'à l'obtention de la structure grenat.

Ce procédé présente comme inconvénient principal de conduire à des grenats impurs qui sont contaminés par les impuretés résultant de réactions de décomposition incomplètes (par exemple, présence d'oxychlorure de terres rares).

Par ailleurs, il est connu d'après Chemical Abstracts Volume 83, 1975, référence 82187s, de fabriquer un oxyde mixte polycristallin de structure grenat par un procédé comprenant les étapes suivantes:

— $\alpha$) on forme une solution aqueuse contenant les sels des cations constitutifs de l'oxyde mixte dans les proportions correspondant à la composition de celui-ci,
— $\beta$) on ajoute ladite solution à une base faible ($Me_4NOH$) pour co-précipiter les oxydes et/ou hydroxydes correspondants,
— $\gamma$) on calcine le co-précipité obtenu à 1000°C dans l'air pendant 1 heure puis à 1400°C pendant 4 heures.

On connaît, de plus, d'après le brevet US 3 386 919 un procédé de fabrication d'un oxyde mixte polycristallin de structure pérovskite par co-précipitation des hydroxydes de lanthane et d'aluminium (ou de gallium) avec l'ammoniaque à partir d'une solution contenant les sels (nitrates) correspondants, puis séchage du co-précipité et calcination 5 heures à 1650°C. Les solutions de nitrate sont obtenues par dissolution d'oxyde de lanthane très pur (99,997%) et d'alun très pur avec de l'acide nitrique.

La demanderesse a mis au point un procédé de fabrication d'un oxyde mixte polycristallin présentant la structure grenat à partir duquel on peut étirer un monocristal parfait. Ce procédé remédie aux inconvénients des procédés antérieurs et il présente de très nombreux avantages. De plus, la poudre obtenue est composée de particules dont les dimensions élémentaires sont de l'ordre de quelques microns et présente des agglomérats de ces particules selon un assemblage compact qui facilite le remplissage du creuset d'étirage tout particulièrement à chaud.

La présente invention concerne en effet un procédé de fabrication de grenat polycristallin du type comportant les étapes suivantes:

1) on prépare une solution contenant les sels des cations constitutifs du grenat dans les proportions correspondant à la composition de celui-ci;
2) on opère la coprécipitation des hydroxydes correspondants par une base pour obtenir un co-hydroxyde;
3) on laisse éventuellement mûrir le co-hydroxyde;
4) on le filtre;
5) on le lave;
6) on le sèche;
7) puis, on le calcine à une température supérieure à la température de formation de la structure grenat désirée;

caractérisé en ce que, selon la première étape, la solution contenant les sels des cations constitutifs du grenat a été préparée selon le procédé comportant les étapes suivantes:

a) on calcine les oxydes des cations entrant dans la composition du grenat; la température et la durée de la calcination sont choisies de façon à correspondre pour l'oxyde à une perte de poids maximale,
b) on pèse les quantités d'oxydes fixées par la formule du grenat,
c) on dissout les oxydes dans un acide fort,
d) on mélange les solutions de sels obtenues.

La présente invention concerne également les monocristaux obtenus à partir de ces grenats polycristallins, en particulier par tirage selon Czochralski.

Le procédé selon la présente invention présente de très nombreux aventages par rapport aux procédés de l'art antérieur, en particulier, il permet:

— d'obtenir la structure grenat par calcination à une température plus basse et pendant un temps moins long que dans les procédés de l'art antérieur;
— d'obtenir la structure grenat en dehors de l'enceinte de tirage du monocristal, ce qui assure la connaissance exacte de la composition du grenat polycristallin de départ grâce à la possibilité de caractérisation de celui-ci (par exemple par mesure du paramètre cristallin);
— d'obtenir une réaction de formation de la structure grenat absolument complète: le grenat polycristallin abtenu est pur, en particulier, il ne contient pas d'oxydes n'ayant pas réagi.

Ainsi, au cours du chauffage du grenat polycristallin dans le creuset de tirage, l'évaporation des sous-espèces de certains oxydes est beaucoup moins importante que dans les procédés de l'art antérieur. Ceci se traduit lors du tirage du grenat monocristallin par les avantages supplémentaires suivants:

— La connaissance exacte de la composition du bain fondu au moment du tirage évite d'employer des relations empiriques visant à corriger les diverses évaporations.
— La limitation de la formation de sous-espèces de certains oxydes permet de restreindre les réactions entre ces sous-espèces et le creuset de tirage, ce qui permet de limiter, d'une part, l'attaque et la destruction rapide du creuset et, d'autre part, des inclusions du métal constituant le creuset dans le monocristal tiré. Ces derniers avantages s'avèrent d'une importance pratique considérable notamment dans le cas particulier du tirage des monocristaux de $Gd_3Ga_5O_{12}$ dans un creuset d'iridium.

Les grenats peuvent être représentés par la formule générale

$$C_3 \quad A_2 \quad (D_3) \quad O_{12}$$

dans laquelle C, A, D représentent un ou plusieurs cations situés respectivement dans les sites dodécaedriques, octaédriques et tétraédriques de la structure cristallographique.

Les différents cations dont on a observé expérimentalement qu'ils pouvaient occuper un ou deux de ces trois types de site sont indiqués dans le tableau ci-dessous (d'après S. Geller Zeitschrift für Kristallographie 125 (1967) 1—47).

0 030 170

Tableau

1    $Na^+$, $Cu^{2+}$, $Mg^{2+}$, $Ca^{2+}$, $Si^{2+}$, $Ba^{2+}$, $Zn^{2+}Cd^{2+}$, $Y^{3+}$, $La^{3+}$, $Ce^{3+}$, $Pr^{3+}$, $Nd^{3+}$, $Sm^{3+}$, $Eu^{3+}$, $Gd^{3+}$, $Tb^{3+}$, $Dy^{3+}$, $Ho^{3+}$, $Er^{3+}$, $Tm^{3+}$, $Yb^{3+}$, $Lu^{3+}$, $Zr^{4+}$, $Hf^{4+}$, $Bi^{3+}$, $Mn^{2+}$, $Fe^{2+}$, $Co^{2+}$

2    $Li^+$, $Cu^{2+}$, $Mg^{2+}$, $Zn^{2+}$, $Sc^{3+}$, $Y^{3+}$, $Lu^{3+}$, $Yb^{3+}$, $Tm^{3+}$, $Er^{3+}$, $Ho^{3+}$, $Dy^{3+}$, $Al^{3+}$, $Ga^{3+}$, $In^{3+}$, $Ti^{4+}$, $Zr^{4+}$, $Hf^{4+}$, $Ge^{4+}$, $Sn^{4+}$, $V^{3+}$, $Nb^{5+}$, $Ta^{5+}$, $Sb^{5+}$, $Mn^{2+}$, $Mn^{3+}$, $Fe^{2+}$, $Fe^{3+}$, $Co^{2+}$, $Co^{3+}$, $Ru^{4+}$, $Rh^{3+}$, $Ni^{2+}$

3    $Li^+$, $Al^{3+}$, $Ga^{3+}$, $Ti^{4+}$, $Si^{4+}$, $Ge^{4+}$, $Sn^{4+}$, $V^{5+}$, $P^{5+}$, $As^{5+}$, $Fe^{3+}$, $Fe^{4+}$, $Co^{2+}$, $Co^{3+}$

(1) Sites dodécaédriques.
(2) Sites octaédriques.
(3) Sites tétraédriques.


Les grenats que l'on peut fabriquer selon le procédé de la présente invention sont ceux dont les cations constitutifs ont des hydroxydes qui peuvent coexister dans un même domaine de pH avec des solubilités inférieures à $10^{-3}$ mole par litre. A partir des courbes de solubilité des différents hydroxydes, l'homme de l'art peut ainsi établir des listes de compactibilité pour les cations et, en déduire en fonction du tableau d'occupation des sites donné ci-dessus, toutes les formules de grenats qui peuvent être fabriqués selon le procédé de la présente invention.

Un exemple non limitatif de listes de compatibilité est le suivant:

1ère liste:
$Y^{3+}$, $La^{3+}$, $Ce^{3+}$, $Pr^{3+}$, $Nd^{3+}$, $Sm^{3+}$, $Eu^{3+}$, $Gd^{3+}$, $Tb^{3+}$, $Dy^{3+}$, $Ho^{3+}$, $Er^{3+}$, $Tm^{3+}$, $Yb^{3+}$, $Lu^{3+}$, $Sc^{3+}$, $Al^{3+}$, $Ga^{3+}$, $In^{3+}$, $Cr^{3+}$, $Fe^{3+}$, $Mn^{3+}$, $Zn^{2+}$, $Cd^{2+}$, $Co^{3+}$, $Cu^{2+}$, $Nb^{5+}$, $Ta^{5+}$.

2ème liste:
Les mêmes cations que la première liste à l'exclusion de $Ga^{3+}$ et $Al^{3+}$, et en incluant $Mg^{2+}$.

3ème liste:
Les mêmes cations que la première liste à l'exclusion de $Ga^{3+}$, $Al^{3+}$ et $Cr^{3+}$, et en incluant $Ca^{2+}$ et $Sr^{2+}$.


Ainsi qu'il est bien connu de l'homme de l'art, les domaines d'existance des solutions solides des structures grenats ne sont pas toujours centrés sur la composition donnée par la formule générale mais ils sont très légèrement décalés par rapport à celle-ci; le procédé selon la présente invention couvre également de telles compositions.

Le procédé de fabrication de grenat polycristallin selon la présente invention comporte une première étape de préparation d'une solution contenant les sels des cations constitutifs du grenat dans les proportions correspondant à la composition de celui-ci.

Ces sels peuvent contenir un anion minéral ou organique. On peut notamment mettre en œuvre des solutions de nitrates, de chlorures, de sulfates, de formiates, d'acétates ou de perchlorates.

Cette solution est préparée selon le procédé comportant les étapes suivantes:

a)    on calcine les oxydes des cations entrant dans la composition du grenat;
b)    on pèse les quantités d'oxydes fixées par la formule du grenat;
c)    on dissout les oxydes dans un acide fort;
d)    on mélange les solutions de sels obtenues

Selon l'étape a) de ce procédé on calcine les oxydes entrant dans la composition du grenat. La température et la durée de la calcination sont choisies de telle façon qu'elles correspondent pour l'oxyde à la perte de poids maximale. Les conditions de calcination choisies doivent évidemment permettre l'attaque ultérieure de l'oxyde calciné en milieur acide fort.

Selon l'étape b) de ce procédé, on pèse les quantités d'oxydes fixées par la formule du grenat. La précision de la pesée est adaptée en fonction de la précision de formule du grenat que l'on veut obtenir; il peut ainsi être nécessaire pour certaines formules d'opérer avec une précision de 0,1%.

Selon l'étape c) de ce procédé, on dissout les oxydes dans un acide fort. La dissolution est opérée séparément ou simultanément lorsque les conditions de dissolution de ces oxydes sont voisines. L'acide mis en œuvre peut être pur ou dilué. L'acide peut notamment être choisi parmi le groupe comprenant: l'acide chlorhydrique, l'acide nitrique, l'acide sulfurique, l'acide perchlorique. On utilise

4

avantageusement l'acide chlorhydrique ou l'acide nitrique.

Les conditions de dissolution varient selon les acides mis en œuvre. La rapidité de la dissolution complète des oxydes dépend notamment de la nature de l'acide, de sa concentration et de la température. De bonnes conditions sont généralement obtenues lorsque la dissolution est opérée avec des acides purs concentrés à l'ébullition, une concentration supérieure à 5 N s'avère avantageuse. La dimension des particules d'oxyde n'est pas un facteur critique selon le procédé de l'invention. Toutefois, si l'on désire une dissolution assez rapide, il est avantageux de mettre en œuvre des particules ayant une granulométrie assez fine et, de préférence, dont le diamètre est inférieur à 400 micromètres; plus particulièrement, des particules ayant un diamètre compris entre 1 et 50 micronmètres conduisent à une mise en œuvre aisée.

Le mélange selon l'étape d) des solutions de sels obtenues est effectué lorsque les oxydes ont été dissout séparément.

Selon la deuxième étape du procédé selon l'invention, on effectue la coprécipitation des hydroxydes correspondants par une base pour obtenir un co-hydroxyde.

La coprécipitation est opérée sous agitation. Comme base, on utilise, de préférence, une base faible telle que l'ammoniaque, l'urée, l'hexaméthylène tétramine, le carbamate d'ammonium...; la concentration de la base est supérieure de préférence à 5 N.

Selon la troisième étape du procédé selon l'invention, on laisse mûrir le co-hydroxyde obtenue pendant une durée comprise entre 1 et 20 heures. Si la précipitation du co-hydroxyde est complète cette étape de mûrissement peut éventuellement être supprimée.

Selon la quatrième étape du procédé de l'invention, on opère la filtration du co-hydroxyde obtenu sous pression ou sous vide. L'élément filtrant mis en œuvre doit présenter, de préférence, une porosité très faible de 1 à 5 micromètres. Ainsi qu'il est bien connu de l'homme de l'art, la filtrabilité du co-hydroxyde peut être mise en œuvre en ajoutant au précipité, avant ou après le mûrissement, un agent floculant décomposable à basse température.

Selon la cinquième étape du procédé de l'invention, on lave ensuite le co-hydroxyde. Le lavage est, de préférence, opéré avec de l'eau jusqu'à l'obtention d'eaux de lavage présentant un pH voisin de la neutralité. Ce lavage a essentiellement pour but d'éliminer les sels adsorbés, il peut notamment s'effectuer soit par transfert à travers le gâteau de co-hydroxyde d'un certain volume d'eau, soit par remise en suspension du gâteau de filtration.

Selon la sixième étape du procédé de l'invention, on sèche ensuite le co-hydroxyde à l'air ou sous vide à des températures comprises entre 100°C et 200°C pendant 10 à 48 heures. Ce séchage est, de préférence, opéré à l'étuve à une température comprise entre 110 et 150°C pendant un temps compris entre 10 et 30 heures.

Selon la septième étape du procédé de l'invention, on calcine le produit séché à une température supérieure à la température de formation de la structure du grenat considéré.

Pour un grenat déterminé, la température et la durée de la calcination dépendent, d'une part, de la température de formation de la structure grenat à partir du co-hydroxyde, température que l'homme de l'art détermine sans difficulté à partir des courbes d'analyse thermique différentielle obtenues sur le produit séché et, d'autre part, des conditions d'utilisation ultérieure du grenat polycristallin calciné. Dans ces conditions, une température de calcination comprise entre 800 et 1500°C et un temps compris entre 1 à 30 heures conviennent généralement. La calcination est généralement effectuée sous air ou sous atmosphère inerte.

Le grenat polycristallin obtenu est caractérisable par diffraction X: on peut vérifier sa structure grenat, contrôler son homogénéïté en vérifiant qu'aucune autre structure n'est visible (en particulier, on ne détecte pas d'oxydes n'ayant pas réagi) et mesurer son paramètre de réseau.

La connaissance exacte de la composition du grenat polycristallin est un des avantages du procédé selon l'invention pour le tirage subséquent du monocristal.

Par ailleurs, la microscopie électronique à balayage révèle l'existence de cristaux élémentaires dont les dimensions sont de l'ordre de quelques micromètres, ces cristaux pouvant s'agglomérer selon un assemblage compact.

La surface spécifique du grenat polycristallin obtenu selon le procédé de la présente invention est généralement faible, sa masse volumique est voisine de 6.

La présente invention concerne également les monocristaux obtenus à partir des grenats polycristallins fabriqués selon le procédé décrit ci-dessus. Les monocristaux de grenat peuvent notamment être fabriqués à l'aide de la technique connue de tirage de cristal selon Czochralski.

Les avantages qui ont été rappelés ci-dessus et, en particulier, la limitation de l'inclusion du métal constituant le creuset et la longévité du creuset par rapport aux techniques de l'art antérieur entrainent l'intérêt industriel considérable de la présente invention.

Les monocristaux à structure grenat obtenus à partir des grenats polycristallins de l'invention sont utilisable dans tous les domaines où de tels matériaux présentent de l'intérêt et, en particulier, dans l'électronique comme substrats pour la fabrication des dispositifs de mémoires à bulles magnétiques.

Les très nombreux avantages de l'invention tant au niveau du grenat polycristallin que du tirage du monocristal ont été donnés ci-dessus. L'exemple suivant illustre l'invention sans en limiter la portée.

## Exemple 1

Cet exemple illustre la préparation du grenat polycristallin de gallium-gadolinium selon le procédé de l'invention.

La composition stoechiométrique de ce grenat est $Gd_{3,00}Ga_{5,00}O_{12}$ et il existe une solution solide de la structure grenat qui n'est pas centrée sur cette composition mais décalée vers les compositions riches en gadolinium. Plus particulièrement, la composition à fusion congruente (voisine de $Gd_{3,04}Ga_{4,96}O_{12}$) est différente de la composition stoechiométrique et il est préférable dans ces conditions, lorsque l'on souhaite tirer le grenat monocristallin par la méthode de Czochralski de partir d'un grenat polycristallin dont la composition est comprise entre la congruence et la stoechiométrie.

L'exemple ci-après est relatif à la préparation du grenat polycristallin de composition $Gd_{3,01}Ga_{4,99}O_{12}$. On a opéré selon les étapes suivantes:

1a) On calcine l'oxyde de gadolinium $Gd_2O_3$ et l'oxyde de gallium $Ga_2O_3$ pendant 15 heures à 1200°C;

1b) On pèse 5673,8 grammes de $Gd_2O_3$ calciné et 4863,7 grammes de $Ga_2O_3$ calciné;

1c) On dissout l'oxyde de gadolinium dans 17 litres d'acide nitrique, 6,4 N dans un réacteur en pyrex de 100 litres muni d'un agitateur revêtu de polytétrafluoroéthylène (PTFE): la dissolution est rapide et exothermique, on a opéré avec un condenseur de 1 m² à reflux total.

On dissout l'oxyde de gallium dans 32 litres d'acide nitrique 6,4 N dans un réateur en pyrex de 100 litres chauffé et muni d'un agitateur revêté PTFE: la dissolution complète à 100°C sous reflux total (condenseur de 1 m²) a duré 8 heures.

1d) On mélange et on homogénéîse les deux solutions de nitrates dans une cuve de 120 litres en polypropylène;

2) On coprécipite l'hydroxyde mixte de gallium et de gadolinium en versant la solution de nitrates dans une solution d'ammoniaque 6 N à une température de 20—25°C jusqu'à l'obtention d'un pH égal à 8,70. La coprécipitation a été opérée dans un réacteur en pyrex de 200 litres muni d'un agitateur revêtu de PTFE, la durée totale de la coprécipitation a été de 5 heures.

3) On laisse mûrir le co-hydroxyde de gallium-gadolinium obtenu pendant 3 heures à la température ambiante, sous agitation.

4) On filtre le co-hydroxyde sur un filtre sous vide de type Nutche de 140 cm de diamètre: l'élément filtrant est une toile polypropylène, l'épaisseur du gâteau est de 40 mm.

5) On effectue un lavage du gâteau par transfert d'eau à travers celui-ci avec 5 fois 50 litres d'eau.

6) On sèche à l'étude sous vide le gâteau pendant 15 heures à 130°C dans des plateaux inox recouverts de PTFE: la perte de poids du gâteau est d'environ 75%.

7) On calcine le produit obtenu après sèchage pendant 5 heures à 1350°C dans des creusets en alumine frittée de haute pureté, sous argon. La température de calcination utilisée est très supérieure à la température de formation de la structure grenat à partir du co-hydroxyde qui est de 820°C (déterminée à partir de la courbe d'analyse thermique différentielle) mais s'avère avantageuse pour donner un grenat polycristallin directement fusible lors d'un tirage Czochralski sans autre traitement.

La perte de poids au cours de la calcination est de 18,2% et on obtient le grenat polycristallin avec un rendement de 96% par rapport à la quantité de nitrate utilisée.

La caractérisation en diffraction X du produit obtenu révèle que seule la structure grenat est visible (pas de structure $Ga_2O_3$ et/ou de structure $Gd_2O_3$).

La mesure du paramètre de réseau donne a = 12,378 Å ce qui correspond bien à la composition $Gd_{3,01}Ga_{4,99}O_{12}$ désirée.

Le monocristal obtenu par tirage Czolchralski à partir de ce grenat polycristallin est parfait. Le tirage s'effectue avec tous les avantages donnés dans la présente demande.

## Exemple 2

### Exemple comparatif

Cet exemple illustre l'un des avantages du procédé selon l'invention par rapport au procédé de l'art antérieur couramment utilisé pour la préparation des grenats polycristallins.

On a préparé le grenat polycristallin de compositions $Gd_{3,01}Ga_{4,99}O_{12}$ selon les étapes suivantes:

1. On calcine de l'oxyde de gadolinium $Gd_2O_3$ et de l'oxyde de gallium $Ga_2O_3$ pendant 15 heures à 1200°C.

2. On pèse 5673,8 grammes de $Gd_2O_3$ calciné et 4863,7 grammes de $Ga_2O_3$ calciné.

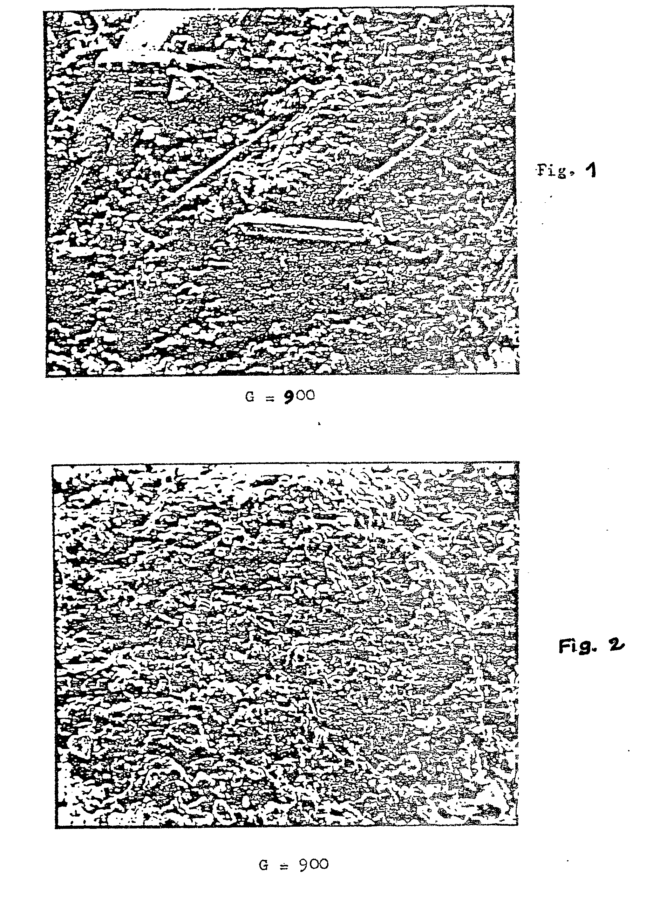

3. On mélange ces oxydes puis on calcine 100 heures à 1350°C. On obtient un grenat polycristallin dans lequel 10% en poids d'oxyde de gallium n'a pas réagi. L'analyse de ce produit par microscopie éléctronique à balayage révèle l'existence de cristaux aciculaires de $Ga_2O_3$ n'ayant pas réagi, la photo donnée à la figure 1 illustre un tel produit.

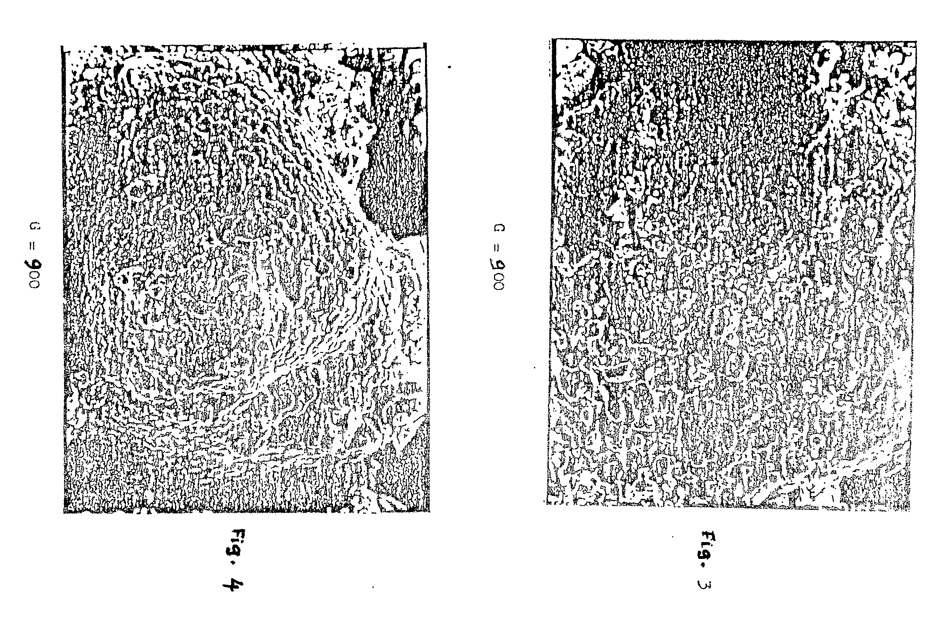

Par comparaison, le grenat polycristallin obtenu selon le procédé de l'invention décrit à l'exemple 1 se révèle présenter une structure sans inclusion. Des photos de ce grenat qui ont été obtenues par microscopie électronique à balayage sont données aux figures 2, 3, 4.

## Revendications

1. Procédé de fabrication de grenat polycristallin du type comportant les étapes suivantes:

1) on prépare une solution contenant les sels des cations constitutifs du grenat dans les proportions correspondant à la composition de celui-ci;
2) on opère la coprécipitation des hydroxydes correspondants par une base pour obtenir un co-hydroxyde;
3) on laisse éventuellement mûrir le co-hydroxyde;
4) on le filtre;
5) on le lave;
6) on le sèche;
7) puis, on le calcine à une température supérieure à la température de formation de la structure grenat désirée;

caractérisé en ce que, selon la première étape, la solution contenant les sels des cations constitutifs du grenat a été préparée selon le procédé comportant les étapes suivantes:

a) On calcine les oxydes des cations entrant dans la composition du grenat; la température et la durée de la calcination sont choisies de façon à correspondre pour l'oxyde à une perte de poids maximale,
b) on pèse les quantités d'oxydes fixées fixées par la formule du grenant,
c) on dissout les oxydes dans un acide fort,
d) on mélange les solutions de sels obtenues.

2. Procédé selon la revendication 1, caractérisé en ce que selon la première étape, les sels sont choisis parmi le groupe comprenant: les nitrates, les chlorures, les sulfates, les formiates, les acétates, les perchlorates.

3. Procédé selon la revendication 1, caractérisé en ce que selon l'étape c) on dissout séparément les oxydes dans un acide fort.

4. Procédé selon la revendication 1, caractérisé en ce que selon l'étape c) on dissout simultanément les oxydes dans un acide fort.

5. Procédé selon les revendications 1, 3, 4 caractérisé en ce que, l'acide fort est mis en œuvre pur on dilué, il est choisi parmi le groupe comprenant: l'acide chlorhydrique, l'acide nitrique, l'acide sulfurique, l'acide perchlorique.

6. Procédé selon les revendications 1, 3, 4, 5, caractérisé en ce que la dissolution est opérée avec l'acide pur concentré à l'ébullition, la concentration de l'acide étant de préférence supérieure à 5 N.

7. Procédé selon la revendication 1, caractérisé en ce que selon la seconde étape, la base est une base faible de préférence choisie parmi le groupe comportant l'ammoniaque, l'urée, l'hexaméthylène tétramine, le carbamate d'ammonium.

8. Procédé selon les revendications 1 ou 7, caractérisé en ce que selon la seconde étape la concentration de la base est supérieure à 5 N.

9. Procédé selon la revendication 1, caractérisé en ce que selon la troisième étape, le mûrissement est effectué pendant 1 à 20 heures.

10. Procédé selon la revendication 1, caractérisé en ce que selon la quatrième étape, on filtre le co-hydroxyde sous pression ou sous vide, l'élément filtrant mis en œuvre ayant de préférence une porosité de 1 à 5 micromètres.

11. Procédé selon la revendication 1, caractérisé en ce que selon la cinquième étape, on lave le co-hydroxyde avec de l'eau jusqu'à l'obtention d'eaux de lavage présentant un pH voisin de la neutralité.

12. Procédé selon la revendication 1, caractérisé en ce que selon la sixième étape, on sèche le co-hydroxyde à l'air ou sous vide à une température comprise entre 100 et 200°C pendant 10 à 48 heures.

13. Procédé selon la revendication 1, caractérisé en ce que selon la septième étape, on calcine le co-hydroxyde à une température comprise entre 800 et 1500°C pendant 1 à 30 heures.

**Patentansprüche**

1. Verfahren zur Herstellung von polykristallinem Granat des die folgenden Stufen umfassenden Typs:

1. Man stellt eine Lösung her, die die Salze der den Granat bildenden Kationen in den der Zusammensetzung des Granats entsprechenden Anteilen enthält;
2. man führt eine Copräzipitation der entsprechenden Hydroxide mit einer Base durch, um ein Co-Hydroxid zu erhalten;
3. man läßt das Co-Hydroxid gegebenenfalls reifen;
4. man filtriert es;
5. man wäscht es;
6. man trocknet es
7. und calciniert es bei einer Temperatur über der zur Bildung der Granatstruktur gewünschten Temperatur;

dadurch gekennzeichnet, daß gemäß der ersten Stufe die Lösung, die die Salze der wesentlichen Kationen des Granats enthält, nach dem die folgenden Stufen umfassenden Verfahren hergestellt wurde:

a) man calciniert die Oxide der Kationen gemäß der Zusammensetzung von Granat; die Temperatur und die Dauer der Calcinierung werden so gewählt, daß sie dem Oxid mit einem maximalen Gewichtsverlust entsprechen,
b) man wiegt die durch die Formel von Granat festgelegten Oxidmengen ab,
c) man löst die Oxide in einer starken Säure,
d) man mischt die Lösungen der erhaltenen Salze.

2. Verfahren nach Anspruch 1, dadurch gekennzeichnet, daß die Salze aus der die Nitrate, Chloride, Sulfate, Formiate, Acetate und Perchlorate umfassenden Gruppe gewählt sind.

3. Verfahren nach Anspruch 1, dadurch gekennzeichnet, daß man gemäß Stufe c) die Oxide getrennt in einer starken Säure löst.

4. Verfahren nach Anspruch 1, dadurch gekennzeichnet, daß man gemäß der Stufe c) die Oxide gleichzeitig in einer starken Säure löst.

5. Verfahren nach den Ansprüchen 1, 3 und 4, dadurch gekennzeichnet, daß die starke Säure rein oder verdünnt eingesetzt und aus der Gruppe enthaltend Salzsäure, Salpetersäure, Schwefelsäure und Perchlorsäure ausgewählt ist.

6. Verfahren nach den Ansprüchen 1, 3, 4 und 5, dadurch gekennzeichnet, daß die Auflösung mit der reinen konzentrierten siedenden Säure durchgeführt wird, wobei die Konzentration der Säure vorzugsweise über 5 N liegt.

7. Verfahren nach Anspruch 1, dadurch gekennzeichnet, daß gemäß der zweiten Stufe die Base eine schwache, vorzugsweise aus der Gruppe von Ammoniak, Harnstoff, Hexamethylentetramin und Ammoniumcarbamat gewählte Base ist.

8. Verfahren nach Anspruch 1 oder 7, dadurch gekennzeichnet, daß gemäß der zweiten Stufe die Konzentration der Base über 5 N ist.

9. Verfahren nach Anspruch 1, dadurch gekennzeichnet, daß gemäß der dritten Stufe die Reifung während 1 bis 20 h vorgenommen wird.

10. Verfahren nach Anspruch 1, dadurch gekennzeichnet, daß gemäß der vierten Stufe das Co-Hydroxid unter Druck oder unter Vakuum filtriert wird, wobei das eingesetzte Filterelement vorzugsweise eine Porosität von 1 bis 5 Mikrometer hat.

11. Verfahren nach Anspruch 1, dadurch gekennzeichnet, daß gemäß der fünften Stufe das Co-Hydroxid mit Wasser bis zum Erhalt von Waschwasser mit einem pH in der Nähe des Neutralpunkts gewaschen wird.

12. Verfahren nach Anspruch 1, dadurch gekennzeichnet, daß man gemäß der sechsten Stufe das Co-Hydroxid an der Luft oder unter Vakuum bei einer Temperatur zwischen 100 und 200° C in 10 bis 48 h trocknet.

13. Verfahren nach Anspruch 1, dadurch gekennzeichnet, daß man in der siebten Stufe das Co-Hydroxid bei einer Temperatur zwischen 800 und 1500° C während 1 bis 30 h calciniert.

**Claims**

1. Process for the manufacture of polycrystalline garnet, of the type comprising the following steps:

1) a solution containing the salts of the constituent cations of the garnet, in the proportions corresponding to the composition of the latter, is prepared;

2) the corresponding hydroxides are co-precipitated by a base in order to give a co-hydroxide;
3) if appropriate, the co-hydroxide is left to age;
4) it is filtered off;
5) it is washed;
6) it is dried; and
7) it is then calcined at a temperature above the temperature for the formation of the desired garnet structure,

characterised in that, in the first step, the solution containing the salts of the constituent cations of the garnet has been prepared by the process comprising the following steps:

a) the oxides of the cations forming part of the composition of the garnet are calcined, the calcination temperature and the calcination time being chosen so as to correspond to a maximum loss in weight for the oxide,
b) the amounts of oxides fixed by the formula of the garnet are weighed out,
c) the oxides are dissolved in a strong acid, and
d) the resulting solutions of salts are mixed.

2. Process according to claim 1, characterized in that, in the first step, the salts are chosen from amongst the group comprising: nitrates, chlorides, sulphates, formates, acetates and perchlorates.

3. Process according to claim 1, characterized in that, in step c), the oxides are dissolved separately in a strong acid.

4. Process according to claim 1, characterized in that, in step c), the oxides are dissolved simultaneously in a strong acid.

5. Process according to claims 1, 3 and 4, characterized in that the strong acid is used pure or dilute and is chosen from amongst the group comprising: hydrochloric acid, nitric acid, sulphuric acid and perchloric acid.

6. Process according to claims 1, 3, 4 and 5, characterized in that the dissolution is carried out with the pure concentrated acid at the boil, the concentration of the acid preferably being above 5 N.

7. Process according to claim 1, characterized in that, in the second step, the base is a weak base which is preferably chosen from amongst the group comprising ammonia, urea, hexamethylenetetramine and ammonium carbamate.

8. Process according to claims 1 or 7, characterized in that, in the second step, the concentration of the base is above 5 N.

9. Process according to claim 1, characterized in that, in the third step, the ageing is carried out for 1 to 20 hours.

10. Process according to claim 1, characterized in that, in the fourth step, the co-hydroxide is filtered off under pressure of in vacuo, the filtering element used preferably having a pore size of 1 to 5 micrometres.

11. Process according to claim 1, characterized in that, in the fifth step, the co-hydroxide is washed with water until the wash waters obtained have a pH in the region of neutality.

12. Process according to claim 1, characterized in that, in the sixth step, the co-hydroxide is dried in air or in vacuo at a temperature of between 100 and 200° C for 10 to 48 hours.

13. Process according to claim 1, characterized in that, in the seventh step, the co-hydroxide is calcined at a temperature of between 800 and 1,500° C for 1 to 30 hours.

Fig. 1

G = 900

Fig. 2

G = 900

Fig. 3

G = 900

Fig. 4

G = 900